# DEMANDE DE BREVET EUROPEEN

(11) **EP 2 674 516 A1**
(43) Date de publication de la demande: **18.12.2013**
(21) Numéro de dépôt: 13171592.2
(22) Date de dépôt: 12.06.2013
(51) Int. Cl.: C25D 3/38, C25D 9/08

(54) **Méthode de fabrication de nanofils de CuSCN par voie électrochimique**

(30) Priorité: 15.06.2012 FR 1255604
(71) Demandeur: COMMISSARIAT A L'ENERGIE ATOMIQUE ET AUX ENERGIES ALTERNATIVES, 75015 Paris (FR)
(72) Inventeur: CHAPPAZ GILLOT, Cyril, 38240 MEYLAN (FR); BERSON, Solenn, 73000 CHAMBERY (FR); IVANOVA-HRISTOVA, Valentina, 38000 GRENOBLE (FR); SALAZAR ROMERO, Raul, 91054 ERLANGEN (DE)
(74) Mandataire: Cabinet Laurent & Charras

(57) **Abrégé**

Ce procédé d'élaboration, sur un substrat conducteur ou semi-conducteur, de nanofils à base de CuSCN comprenant les étapes suivantes :
- préparation d'une solution aqueuse électrolytique à partir d'un sel de Cu(II) à une concentration inférieure à 120 mM, d'un complexant de Cu(II) de la famille des acides aminocarboxyliques et d'un sel de thiocyanate, ladite solution présentant un pH compris entre 0,1 et 3 ;
- dépôt par voie électrochimique de la solution aqueuse électrolytique sur le substrat.

## Description

### DOMAINE DE L'INVENTION

L'invention concerne un procédé de dépôt par voie électrochimique permettant d'obtenir des nanostructures de CuSCN, notamment des nanofils, sur un substrat conducteur électriquement ou semi-conducteur.

De telles nanostructures peuvent servir de semi-conducteur transparent de type p, sur un substrat conducteur électriquement ou semi-conducteur, dans un dispositif optoélectronique tel qu'une diode électroluminescente organique (OLED pour l'acronyme anglo-saxon «*Organic Light-Emitting Diode* »), une diode électroluminescente à polymère (PLED pour l'acronyme anglo-saxon «*Polymer Light-Emitting Diode* »), un dispositif photovoltaïque (PV), ou un OPD (« *Organic Photo Detector* »).

### ETAT ANTERIEUR DE LA TECHNIQUE

Les cellules photovoltaïques (PV) organiques sont des dispositifs capables de convertir l'énergie solaire en énergie électrique grâce à l'utilisation de matériaux semi-conducteurs, pour produire un effet photovoltaïque. Les matériaux actifs, ainsi que les architectures de ces dispositifs, sont encore en évolution afin de répondre aux critères de performances et de durée de vie permettant d'élargir le champ d'application de ces technologies.

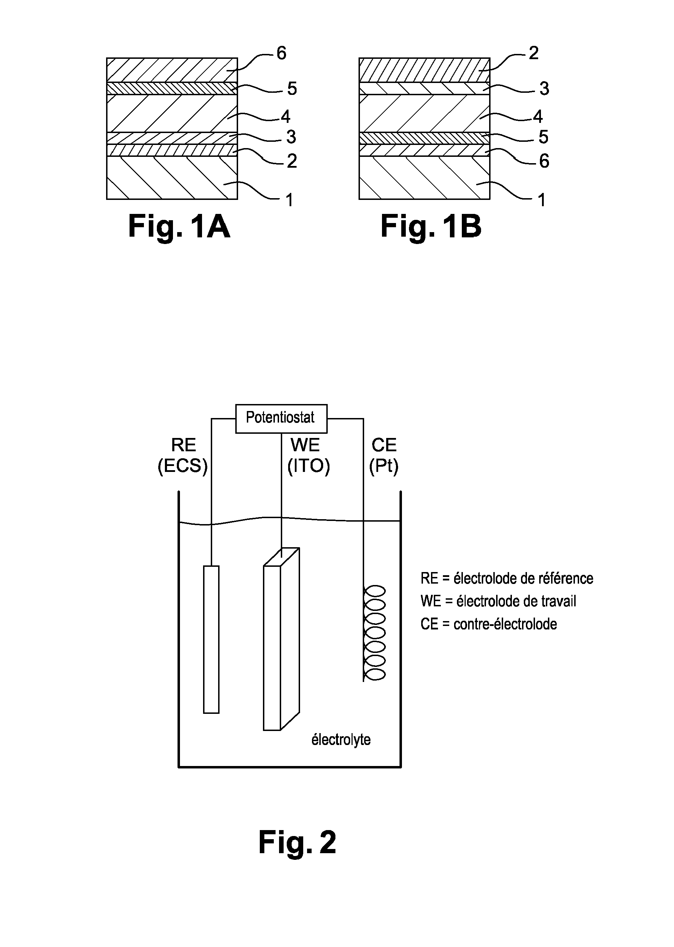

Pour rappel, les structures classique et inverse des cellules PV organiques sont schématisées à la figure 1A et à la figure 1B, respectivement.

Dans une architecture classique, un substrat **1** est recouvert des couches successives suivantes :
- une couche conductrice **2** faisant fonction de première électrode ;
- une couche **3** semi-conductrice de type p ;
- une couche active **4 ;**
- une couche **5** semi-conductrice de type n ; et
- une couche conductrice **6** faisant fonction de seconde électrode.

Dans une structure inverse, l'empilement présente la séquence suivante :
- un substrat **1 ;**
- une couche conductrice **6** faisant fonction de première électrode ;
- une couche **5** semi-conductrice de type n ;
- une couche active **4 ;**
- une couche **3** semi-conductrice de type p ;
- une couche conductrice **2** faisant fonction de seconde électrode.

De nombreux oxydes métalliques transparents et semi-conducteurs de type p ont été utilisés comme couches interfaciales P dans des cellules OPV. Les plus courants sont les oxydes de nickel (NiO), de molybdène (MoO₅), de tungstène (WO₃), ou encore de vanadium (V₂O₅). En revanche, peu de travaux portent sur l'utilisation du CuSCN, alors que ce matériau dispose de propriétés similaires aux oxydes précités, pouvant être déposé par voie électrochimique.

Il a été décrit un procédé de préparation par voie électrochimique de couches cristallines de CuSCN sur des substrats rigides verre/ITO, par réduction cathodique du Cu(II) complexé à la triéthanolamine, en présence d'anions thiocyanates (Ni *et al.,* 2007). Les couches cristallines de CuSCN ainsi formées sont obtenues par croissance homogène dans au moins deux directions (structuration dite en deux dimensions ou « 2D »).

Selk *et al.* (2008) ont décrit un procédé permettant la variation de la morphologie de couches de CuSCN déposées par voie électrochimique sur substrats rigides verre/FTO à partir d'un électrolyte en solvant eau/éthanol.

Wu *et al.* (2005) ont décrit un procédé de préparation par voie électrochimique (en mode potentiostatique et galvanostatique) de couches cristallines de CuSCN sur substrats rigides verre/ITO. Le procédé est réalisé par réduction cathodique du Cu(II) complexé à l'EDTA sous forme disodique, entrainant un pH élevé, en présence d'anions thiocyanates. Les couches obtenues présentent une structuration non ordonnée, dite «2D ».

Wu *et al.* (2007) ont également décrit un procédé de dépôt de CuSCN par voie électrochimique sur un film poreux de TiO₂ de type n. Dans une première étape, une solution électrolytique est préparée comme décrit dans le document Wu *et al.* de 2005, puis le pH est abaissé à 2-2,6 par ajout d'acide sulfurique (H₂SO₄).

Par ailleurs, il a été décrit un procédé d'intégration des couches « 2D » précédemment décrites dans des cellules présentant une structure du type : ITO/CuSCN/P3HT/P3HT:PCBM/A1 (Takahashi *et al.,* 2007).

Enfin, Chen *et al.* (2003) ont décrit un procédé de fabrication de transistors à effet de champ à partir de nanofils verticaux de CuSCN sur substrat flexible et formés à travers une matrice percée d'ouvertures cylindriques.

Un objet de l'invention tend à développer de nouvelles architectures à base de CuSCN et de nouveaux procédés d'obtention de ces architectures, intégrables dans des dispositifs optoélectronique tels que les OLEDs, les PLEDs, les PVs et les OPDs et permettant d'améliorer leurs rendements et leur stabilité.

### OBJET DE L'INVENTION

La présente invention propose un procédé simple, basé sur le dépôt électrochimique, applicable sur tous types de substrat, notamment conducteur électriquement ou semi-conducteur, et permettant d'élaborer des nanostructures de type nanofils en CuSCN, présentant des propriétés très intéressantes lorsqu'elles sont utilisées en tant que semi-conducteur transparent de type p dans des dispositifs optoélectroniques.

Selon un premier aspect, la présente invention vise donc un procédé d'élaboration, sur un substrat avantageusement conducteur ou semi-conducteur, de nanostructures à base de CuSCN comprenant les étapes suivantes :
- préparation d'une solution aqueuse électrolytique :
   - à partir d'un sel de Cu(II) ayant une concentration inférieure à 120 mM, d'un complexant de Cu(II) de la famille des acides aminocarboxyliques et d'un sel de thiocyanate ;
   - présentant un pH acide, avantageusement compris entre 0,1 et 3 ;
- dépôt par voie électrochimique de ladite solution sur le substrat.

Le procédé selon l'invention permet donc de réaliser des nanostructures à base de CuSCN.

Dans le cadre de l'invention, des nanostructures sont considérées comme des structures dites « 3D », c'est-à-dire qu'elles sont caractérisées par un axe de croissance privilégié dans une direction perpendiculaire au substrat sur lequel elles sont générées. Ainsi, ces nanostructures se différencient clairement d'une couche dite « 2D » formée par des procédés selon l'art antérieur et caractérisée par une croissance homogène dans au moins deux directions.

La distinction entre les nanostructures selon l'invention et une couche 2D de CuSCN peut être faite sur la base de l'analyse de leur structure cristalline à l'aide d'un diffractomètre de rayons X, par exemple de type PANalytical X'Pert MPD en utilisant la radiation K_{α} du cobalt (λ = 1.7890 Â) en mode θ-2θ. Les nanostructures selon l'invention sont caractérisées par au moins un ratio entre l'intensité du pic à 18° et celle du pic à 31°, à 45° ou à 55° supérieur à 15, contrairement à une couche 2D pour laquelle tous les ratios sont inférieurs à 15. En particulier et à titre d'exemple, l'analyse du spectre de DRX des couches réalisées dans l'article de *Wu et al.* permet de calculer un rapport d'intensité de 0.4 pour les pics 18°/31° et 1.7 pour les pics 18°/45°.

Avantageusement, tous les ratios entre l'intensité du pic à 18° et l'intensité de chacun des pics à 31°, à 45° et à 55° sont supérieurs à 15.

Les nanostructures obtenues dans le cadre de l'invention peuvent être avantageusement des nanofils. Dans le cadre de l'invention, on appelle « nanofil » une entité prismatique (par exemple hexagonale) ou cylindrique, de taille nanométrique dont le rapport hauteur sur diamètre (ou facteur de forme FF) est supérieur ou égal à 1,2. Dans le cas d'un facteur de forme proche de 1.2, on parle plutôt de nanoplots.

D'autres nanostructures qui peuvent être envisagées sont notamment des nanotubes ou bâtonnets.

La densité des nanostructures formées à l'issue du procédé selon l'invention est directement liée au taux des sites de nucléation du CuSCN sur le substrat. De manière privilégiée, la densité des nanostructures est suffisamment importante pour que la couche formée soit dite continue, c'est-à-dire qu'elle tapisse continuement la surface du substrat sur laquelle elle est formée.

Dans le cadre de l'invention, on entend par « nanostructures à base de CuSCN » le fait que le constituant essentiel, voire exclusif, des nanostructures est le thiocyanate de cuivre ou CuSCN. Toutefois, la présence de contaminations minoritaires n'est pas exclue.

En outre, les nanostructures obtenues selon l'invention présentent une très bonne cristallinité et donc une bonne conductivité électrique. La qualité cristalline du CuSCN est notamment inversement proportionnelle à la largeur à mi-hauteur des pics observés par diffraction aux rayons X.

Les nanostructures en CuSCN selon l'invention sont réalisées à l'aide d'un dépôt par voie électrochimique dans des conditions précises et maîtrisées. D'un point de vue réactionnel, la réduction cathodique du Cu(II) complexé en Cu(I) permet, en présence d'anions thiocyanate (SCN⁻), la précipitation du CuSCN à la cathode, selon la réaction suivante :

Cu²⁺ + e⁻ → Cu⁺

Cu⁺ + SCN⁻ → CuSCN

Alors que cette réaction est bien connue, la contribution de l'invention a résidé dans la mise au point des conditions de dépôt permettant l'obtention des nanostructures recherchées, en l'occurrence des nanofils, et ce sur tout type de substrat notamment conducteur électriquement ou semi-conducteur.

L'électrodépôt de CuSCN s'effectue classiquement dans une cellule électrochimique standard à deux ou trois électrodes, où un fil de Pt est utilisé comme contre-électrode avec éventuellement une électrode au calomel saturé (ECS) comme électrode de référence.

De manière avantageuse, le dépôt est réalisé sur un substrat conducteur ou semi-conducteur, solide et qui peut être rigide ou flexible.

Selon un mode de réalisation particulier, il ne s'agit pas d'un substrat poreux, tel qu'un film de TiO₂, notamment un film de TiO₂ de type n. En d'autres termes et selon ce mode de réalisation, le substrat sur lequel est réalisé le dépôt est non poreux.

Il peut s'agir d'un substrat en métal. Alternativement, il peut être formé par au moins une couche en oxyde transparent conducteur (TCO pour l'anglicisme *« Transparent Conductive Oxide* »), par exemple à base de ITO (pour l'anglicisme *« Indium Tin Oxide* » ou *« tin-doped indium oxide* »), de GZO (oxyde de zinc dopé avec du gallium également connu sous l'anglicisme « *Gallium-doped Zinc Oxide* »), d'AZO (oxyde de zinc dopé par de l'aluminium), d'YZO (oxyde de zinc dopé avec de l'Yttrium), d'IZO (oxyde de zinc et d'indium) ou de FTO (oxyde d'étain dopé avec du fluor ou SnO₂:F), disposée sur un support transparent, par exemple en verre ou en plastique (tel que le PET, le PEN ou un polycarbonate). Un substrat conducteur sous forme d'un empilement multi-couches transparent, formé sur un support en verre ou en plastique, peut également être envisagé (par exemple TCO/Ag/TCO).

Selon l'invention, le bain électrolytique servant au dépôt se caractérise comme suit :
Il s'agit avantageusement d'une solution aqueuse, à savoir constituée majoritairement d'eau. De manière préférée, celle-ci ne contient pas d'alcool, notamment pas d'éthanol.

De manière appropriée, cette solution aqueuse électrolytique est préparée à partir de:
- une source de Cu(II), avantageusement un sel de Cu(II), encore plus avantageusement du sulfate de cuivre (notamment CuSO₄,5H₂O) ou du chlorure de cuivre (CuCl₂) ou leurs mélanges. De manière adaptée selon l'invention, la concentration en Cu(II) est inférieure ou égale à 120 mM, avantageusement inférieure ou égale à 80 mM. Par ailleurs, elle est avantageusement supérieure ou égale à 5 mM. Ainsi, elle est plus particulièrement comprise entre 5 mM et 80 mM. Elle peut par exemple être de 5 mM (pH solution = 2.0), 12 mM (pH solution=1.7), 60 mM (pH solution =1.2) ou 80 mM (pH solution =1.1) ;
- un complexant de Cu(II) de la famille des acides aminocarboxyliques ou aminocarboxylates. De manière adaptée selon l'invention, l'acide aminocarboxylique est présent sous forme de polyacide (présentant au moins deux fonctions acide carboxylique). Il s'agit avantageusement d'un acide diamine tétraacétique, par exemple de l'EDTA (acide éthylène diamine tétraacétique) ou du CDTA (trans-1,2-diaminocyclohexane tétraacétique), ou bien de l'EGTA (acide éthylèneglycol tétraacétique) ou du DTPA (acide diéthylène triaminopentaacétique), ou un mélange de ceux-ci. De manière avantageuse, l'acide aminocarboxylique se présente sous forme d'acide et non sous forme d'un sel de celui-ci. Ainsi et dans l'exemple de l'EDTA, celui-ci se présente avantageusement sous forme de C₁₀H₁₆N₂O₈ et non sous forme d'un sel notamment sodique, comme l'EDTA disodique (C₁₀H₁₄N₂O₈.Na₂.2H₂O) ou tétrasodique ; et
- un sel de thiocyanate en tant que source d'anions SCN⁻, tel que le KSCN ou NaSCN ou leurs mélanges.

En outre, cette solution électrolytique présente un pH acide, avantageusement compris entre 0,1 et 3. Ainsi et de manière privilégiée, le pH de la solution est :
- supérieur ou égal à 0,1, avantageusement supérieur ou égal à 1 ;
- inférieur ou égal à 3, avantageusement inférieur ou égal à 2,3, encore plus avantageusement inférieur ou égal à 2, voire même inférieur à 2.

En d'autres termes et de manière avantageuse, le pH de la solution mise en oeuvre dans le cadre de la présente invention est compris entre 0,1 et 3, voire compris entre 0,1 et 2,3 ou entre 0,1 et 2, voire compris entre 1 et 2,3 ou entre 1 et 2, voire même supérieur ou égal à 1 et inférieur à 2, par exemple égal à 1,7.

Selon un mode de réalisation privilégié, ces valeurs de pH sont atteintes par le simple ajout des réactifs en présence. En d'autres termes, après ajout des réactifs, le pH de la solution ne nécessite pas d'être ajusté, en particulier abaissé par l'ajout d'un acide tel que l'acide sulfurique. En effet et dans le cadre de la présente invention, il a été mis en évidence qu'en partant notamment d'un sel de l'acide puis en abaissant le pH par exemple avec H₂SO₄, les nanostructures recherchées, en l'occurrence des nanofils, n'étaient pas obtenues. Sans vouloir être lié à une quelconque théorie, probablement en raison de la présence des sels (Na⁺) et/ou des ions SO₄⁻, la complexation du cuivre s'en trouverait modifiée et la croissance serait différente.

Ainsi, les paramètres importants pour l'obtention des nanostructures selon l'invention sont :
- la nature du complexant ; et
- le pH acide de l'électrolyte ; et
- la concentration relativement faible en Cu(II) de la solution.

Avantageusement, le rapport molaire ou stoechiométrie entre Cu(II) et le complexant du Cu(II), notamment entre Cu(II) et EDTA (Cu(II)/EDTA), est inférieur ou égal à 1/0.8, avantageusement égal à 1/1. En d'autres termes et de manière adaptée, 1 équivalent d'EDTA est ajouté. Un niveau suffisant de complexation est requis et impacte directement le pH de la solution.

En outre et de manière préférée, le rapport molaire ou stoechiométrie entre Cu(II) et le sel de thiocyanate, notamment entre Cu(II) et KSCN (Cu(II)/KSCN), est inférieur ou égal à 1/0.1, avantageusement égal à 1/0.25. En d'autres termes et de manière adaptée, 0.25 équivalent de KSCN sont ajoutés. Il s'avère qu'un apport approprié en thiocyanate par rapport à l'apport en Cu(II) impacte la forme des nanofils.

Selon un autre mode de réalisation privilégié, le dépôt électrochimique, et plus généralement l'ensemble du procédé selon l'invention, se déroule à une température inférieure à 50°C, avantageusement à température ambiante, typiquement comprise entre 20 et 30°C, voire entre 20 et 25°C. Il s'avère qu'une température supérieure favorise l'apparition de structures hétérogènes. Par ailleurs, la température est avantageusement maintenue constante au cours du dépôt par voie électrochimique.

A noter que selon un mode de réalisation privilégié, le procédé selon l'invention exclut toute étape de recuit, généralement réalisée à une température supérieure à la température ambiante.

Le dépôt électrochimique peut en outre être réalisé :
- soit à potentiel constant, en mode potentiostatique ;
- soit en fixant la densité de courant, en mode galvanostatique.

Le potentiel ou la densité de courant est avantageusement choisi de façon à éviter la contamination du CuSCN par du Cu(0) qui précipite à la cathode par réduction des ions Cu(II) complexés. Selon la nature du substrat, le potentiel peut varier de -10 à -480 mV vs ECS en mode potentiostatique, et la densité de courant de -5 à -550 µA.cm-2 en mode galvanostatique. Le contrôle du potentiel est classiquement assuré à l'aide d'un potentiostat/galvanostat de type PARSTAT 2273 (Princeton Applied Research).

Plus précisément et comme il peut être aisément déterminé par l'homme du métier, des conditions limites en fonction du mode d'alimentation et de la nature du substrat en présence sont présentées dans le tableau ci-dessous :

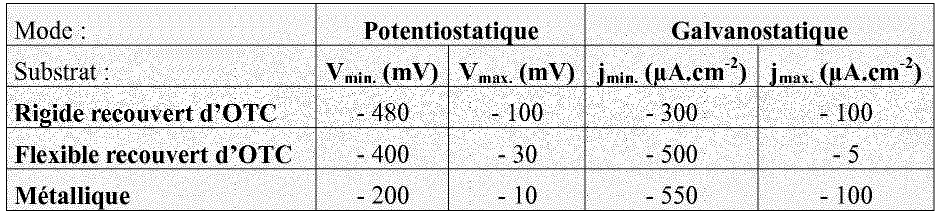

Typiquement, le dépôt par voie électrochimique selon l'invention est réalisé à une densité de charge supérieure à 1 et pouvant par exemple aller jusqu'à 200mC.cm⁻² ou au-delà, essentiellement corrélée à la durée du dépôt et à l'intensité du courant dans la cellule électrochimique. Avantageusement, la densité de charge imposée à la cathode est fixée de manière à ce que le CuSCN recouvre entièrement la surface souhaitée de sorte que les nanostructures forment une couche continue sur le substrat. En pratique, elle peut varier en fonction de la nature du substrat et est déterminée au cas par cas par l'homme du métier. Ainsi et à titre d'exemple, la densité de charge minimale pour un substrat verre/ITO est égale à 1,5 mC.cm⁻².

De manière remarquable, il a été montré que les caractéristiques de l'architecture finale constituée des nanostructures ainsi élaborées peuvent être contrôlées en ajustant les paramètres du procédé, par exemple comme suit :
Concernant le diamètre des nanofils, il a été montré qu'en mode potentiostatique, il augmente avec l'augmentation du potentiel et avec la diminution du rapport molaire Cu(II)/thiocyanate.

Concernant la densité des nanostructures formées à la surface du substrat, celle-ci est liée au taux de nucléation au niveau de la surface à partir de laquelle les nanostructures croissent, ce qui détermine la continuité de la couche ainsi formée.

La longueur (en d'autres termes l'épaisseur de la couche de nanostructures) peut elle-même être contrôlée par la densité de charge imposée à la cathode lors du dépôt électrochimique. Ainsi et globalement, l'épaisseur de la couche constituée des nanostructures de CuSCN augmente avec la densité de charge.

Comme déjà dit, les nanostructures de CuSCN obtenues à l'aide du procédé selon l'invention peuvent constituer la couche semi-conductrice de type p d'un dispositif optoélectronique, tel qu'un panneau photovoltaïque (PV) et plus particulièrement un PV organique, un photo détecteur, une PLED ou une OLED.

En d'autres termes, le procédé selon l'invention peut être utilisé dans l'élaboration d'un dispositif optoélectronique.

Typiquement, dans le cas d'un OPV, un tel dispositif comprend :
- une couche conductrice ;
- une couche semi-conductrice de type p élaborée selon l'invention ;
- une couche semi conductrice de type n ;
- une couche active, typiquement un mélange polymère/fullerène de type poly(3-hexylthiophène/[6,6]-phényl-C₆₁-butyrate de méthyle (P3HT/PC₆₀BM) ou poly[N-9'-heptadecanyl-2,7-carbazole-alt-5,5-(4',7'-di-2-thiényl-2', 1',3'-benzothiadiazole)] /[6,6]-phényl-C₇₁-butyrate de méthyle (PCDTBT/PC₇₀BM). La couche active peut aussi être un mélange polymère/polymère ou molécule/molécule.

Il ressort de la présente demande que la structuration du CuSCN sous la forme de nanostructures, en particulier de nanofils, permet d'augmenter la surface de contact entre la couche active et le semi-conducteur de type p. De tels dispositifs présentent des performances et une stabilité tout à fait adaptées aux applications envisagées.

Ainsi et selon un autre aspect, la présente invention concerne un procédé de fabrication d'un dispositif optoélectronique, selon lequel le dépôt du semi-conducteur transparent de type p sur le substrat est réalisé à l'aide du procédé décrit ci-dessus.

### LEGENDE DES FIGURES

La figure 1 représente un schéma de la structure classique (A) ou inverse (B) de cellules photovoltaïques organiques.
La figure 2 représente le schéma d'une cellule électrochimique, illustré pour un montage à 3 électrodes (RE : électrode de référence ; WE : électrode de travail ; CE : contre-électrode).
La figure 3 représente des images prises par microscopie électronique à balayage (MEB) de nanofils de CuSCN obtenus selon l'invention :
   (A) une vue à 45° sur un substrat rigide verre/ITO, à une densité de charge de 4 mC.cm⁻² ;
   (B) une vue de dessus sur un substrat rigide verre/ITO, à une densité de charge de 50 mC.cm⁻² ;
   (C) une vue en coupe sur un substrat flexible PET/ITO, à une densité de charge de 15 mC.cm⁻².
La figure 4 représente un spectre de diffraction des rayons X (XRD) d'une couche de CuSCN ou de nanofils de CuSCN obtenus selon l'invention, respectivement, sur un substrat rigide verre/FTO.
La figure 5 représente une vue schématique en coupe d'un dispositif photovoltaïque organique (OPV) ou cellule, intégrant des nanofils de CuSCN obtenus selon l'invention.
La figure 6 représente des courbes de densité de courant en fonction du potentiel, des cellules intégrant des nanofils de CuSCN selon l'invention ou d'une couche de référence PEDOT : PSS.
   (A) pour une couche active P3HT/PC₆₀BM ;
   (B) pour une couche active PCDTBT/PC₇₀BM.
La figure 7 représente des courbes de vieillissement des cellules intégrant des nanofils de CuSCN obtenus selon l'invention ou d'une couche de référence PEDOT:PSS, respectivement, dans le cas d'une couche active PCDTBT/PC₇₀BM.

### EXEMPLES DE REALISATION

Les exemples de réalisation qui suivent, à l'appui des figures annexées, ont pour but d'illustrer l'invention mais ne sont en aucun cas limitatifs.

### 1/ Réalisation de nanofils de CuSCN :

L'électrodépôt de CuSCN est réalisé dans une cellule électrochimique standard à trois électrodes, comme illustré à la figure 2. Un fil de Pt est utilisé comme contre-électrode et une électrode au calomel saturé (ECS) comme électrode de référence. L'électrode de travail peut être de différentes natures : soit un métal, soit un substrat transparent (rigide ou flexible) recouvert d'un oxyde conducteur transparent (OTC) comme par exemple l'ITO, le FTO, l'AZO, le GZO... Sa surface active est d'environ 2.0 cm².

La composition électrolyte standard est une solution aqueuse de sulfate de cuivre pentahydraté (CuSO₄ 5H₂O) à 12 mM., contenant 1 équivalent d'acide éthylène-diamine-tétraacétique (EDTA) ou d'acide 1,2-diaminocyclohexane-tetraacétique (CDTA), et 0.25 équivalent de thiocyanate de potassium (KSCN).

Les films minces de CuSCN sont obtenus à température ambiante, par dépôt électrochimique à potentiel constant (mode potentiostatique) ou bien en fixant la densité de courant (mode galvanostatique). Le potentiel est avantageusement choisi de façon à éviter la contamination du CuSCN par du Cu(0) qui précipite à la cathode par réduction des ions Cu(II) complexés. Selon la nature du substrat, le potentiel peut varier de -10 à - 480 mV *vs* ECS en mode potentiostatique, et la densité de courant de -5 à -550 µA.cm⁻² en mode galvanostatique. Le contrôle du potentiel est assuré avec un potentiostat/galvanostat PARSTAT 2273 (Princeton Applied Research).

En mode potentiostatique, le choix du potentiel dans la gamme fixée ci-dessus, permet de contrôler le diamètre des nanofils. Par exemple et comme démontré dans le tableau ci-dessous, pour un substrat PET/ITO, le diamètre moyen des nanofils augmente de 50 nanomètres tous les 100 mV. De même, le diamètre des nanofils diminue lorsque le rapport molaire Cu(II)/thiocyanate augmente. Le facteur de forme moyen des nanofils est également donné à titre indicatif :

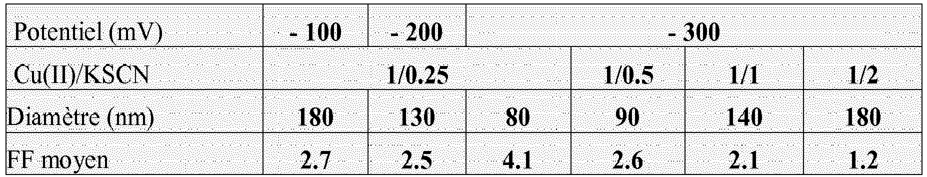

### 2/ Analyse des nanofils de CuSCN obtenus :

Les nanofils de CuSCN, obtenus dans les conditions décrites précédemment, sont cristallins.

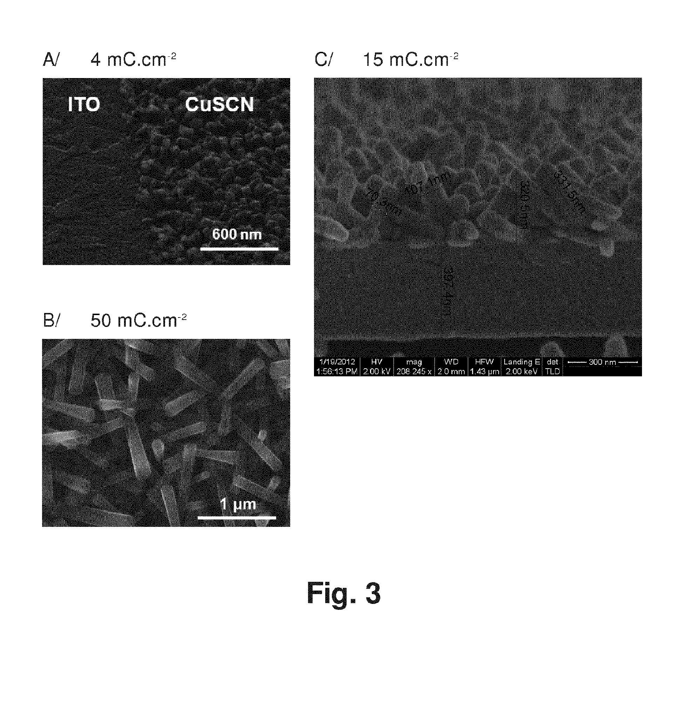

La morphologie des films minces est étudiée à l'aide d'un microscope électronique à balayage Hitachi S-4100 (figure 3). La croissance des nanofils de CuSCN se fait à partir de centres de nucléation à la surface de l'oxyde transparent conducteur (OTC - figure 3B).

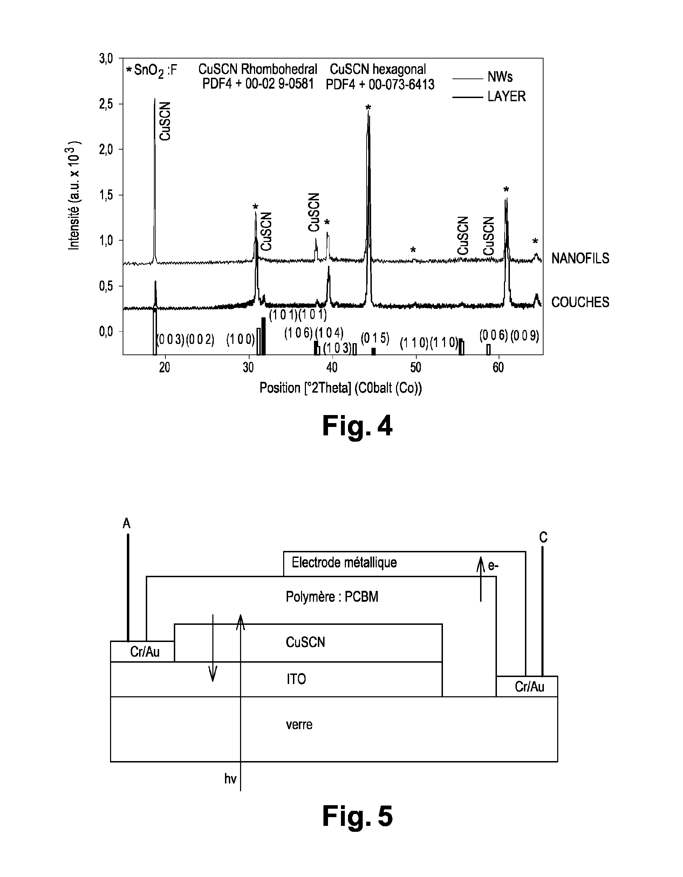

La structure cristalline des nanofils a été analysée par un diffractomètre de rayon X PANalytical X'Pert MPD (figure 4), en utilisant la radiation K_{α} du cobalt (λ = 1.7890 Â) en mode θ-2θ, puis comparée à une couche cristalline de CuSCN sans nanostructuration 3D, obtenue à partir d'un électrolyte Cu(II)/triéthanolamine/KSCN 1:10:5 à 12 mM.

Une caractérisation objective des nanofils peut être obtenue en comparant l'intensité relative de tous les pics du diffractogramme avec celle du pic le plus intense à 18° correspondant aux plans {003} et {002}, comme montré dans le tableau ci-dessous :

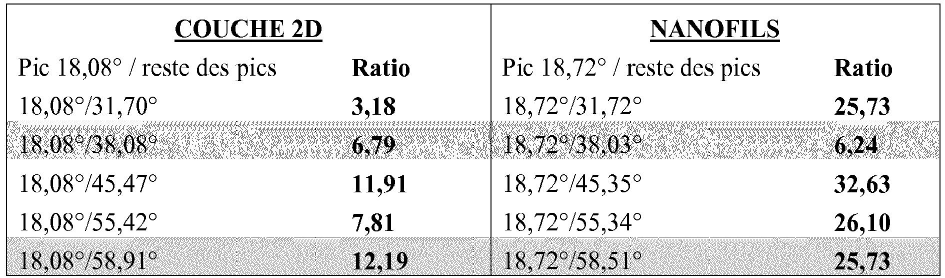

Les rapports 18°/38° et 18°/58°, qui caractérisent des ratios relatifs aux plans multiples {00X}, sont similaires pour les couches et les nanofils. En revanche, tous les autres ratios sont de 3 à 8 fois plus importants pour les nanofils de CuSCN par rapport aux couches, ce qui indique une cristallisation préférentielle des nanofils dans une direction privilégiée (plans {00X}) orthogonale à la surface (figure 3B). Afin de caractériser les nanofils, les ratios entre le pic à 18° et les pics à 31°, 45° et 55° doivent donc être supérieurs à 15.

La densité des nanofils et leur longueur peuvent être contrôlées par la densité de charge imposée à la cathode lors du dépôt électrochimique, qui est fonction du temps de dépôt et de l'intensité du courant dans la cellule électrochimique. Comme montré dans le tableau ci-dessous, l'épaisseur et la rugosité de la couche de CuSCN, mesurées au profilomètre, augmentent globalement avec la densité de charge :

| | | | | | |
|---|---|---|---|---|---|
| Charge imposée pour le dépôt de CuSCN (mC.cm⁻²) | **1.5** | **4** | **10** | **20** | **30** |
| Epaisseur moyenne (nm) | **40** | **85** | **170** | **260** | **400** |
| Rugosité (RMS - nm) | **2.9** | **1.5** | **2.2** | **3.8** | **5.3** |

### 3/ Intégration des nanofils de CuSCN obtenus dans des dispositifs OPV :

Ces nanofils de CuSCN ont été intégrés dans des dispositifs OPV en structure classique (figure 5), et comparés avec des standards de référence contenant une couche semi-conductrice p de PEDOT:PSS.

Deux couches actives polymère/fullerène de nature différente ont été testées : les mélanges P3HT/PC₆₀BM et PCDTBT/PC₇₀BM. Les performances des cellules intégrant des nanofils de CuSCN selon l'invention par rapport aux standards de référence (PEDOT:PSS) sur verre/ITO ont été comparées :

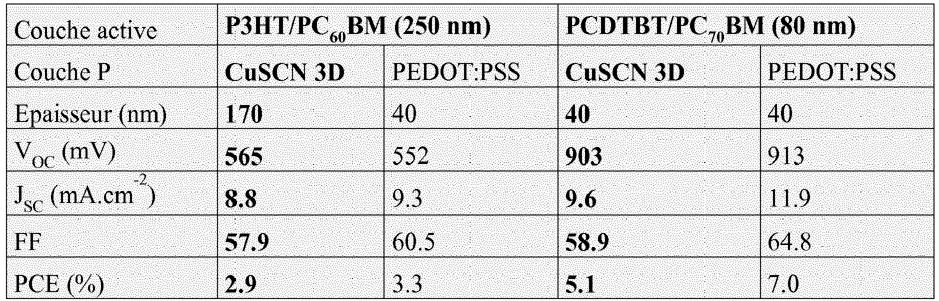

La structuration du CuSCN sous la forme de nanofils permet d'augmenter la surface de contact entre la couche active et le semi-conducteur de type p. Tous les dispositifs OPV réalisés ont une surface active de 28 mm² et sont testés sous illumination AM 1.5, 100 mW.cm⁻².

Le polymère peut être avantageusement choisi de façon à ce que l'énergie de sa plus haute orbitale moléculaire occupée (HOMO) soit inférieure à l'énergie de la bande de valence (BV) du CuSCN (E_{BV} = - 5.3 eV). C'est le cas du PCDTBT (E_{HOMO} = - 5.35 eV), qui semble plus approprié dans le dispositif que le P3HT (E_{HOMO} = - 5.0 eV).

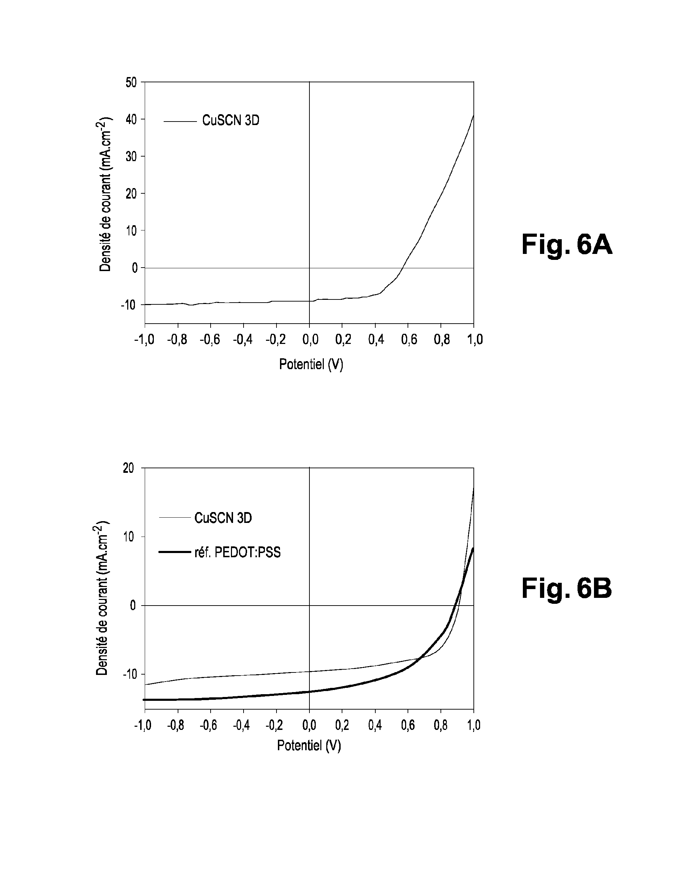

Sur des substrats verre/ITO, les meilleurs résultats ont été obtenus pour des épaisseurs de film de l'ordre de 170 nanomètres pour le P3HT/PC₆₀BM et de 40 nanomètres pour le PCDTBT/PC₇₀BM (figure 6). Les performances diminuent nettement lors de l'augmentation de la longueur des nanofils de CuSCN et donc de l'épaisseur du film, avec une chute de la densité de courant en court-circuit (J_{SC}). Cette dernière reste actuellement la caractéristique limitante du dispositif, alors que la tension en circuit ouvert (V_{OC}) est comparable aux valeurs de référence.

Les rendements de conversion obtenus avec une couche interfaciale de nanofils de CuSCN, bien qu'inférieurs aux cellules standards contenant une couche de PEDOT:PSS, n'ont pas d'antécédent dans la littérature avec ce matériau.

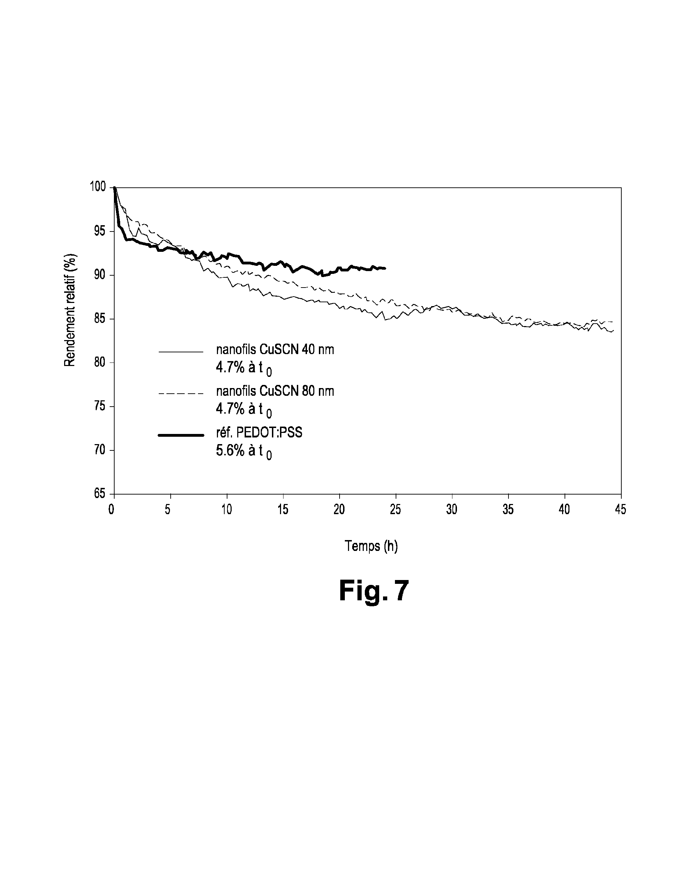

Des études de stabilité ont également été réalisées pour comparer les performances des dispositifs avec les nanofils de CuSCN à celles des dispositifs standards (figure 7). Les 45 premières heures de vieillissement sous illumination continue en boîte à gants montrent une dégradation de l'ordre de 15% des performances des dispositifs intégrant des films minces nanostructurés de moins de 100 nanomètres d'épaisseur. Sur les 25 premières heures, les pertes sont inférieures à 10% par rapport aux dispositifs de référence.

Les performances électriques des cellules réalisées avec une couche active PCDTBT/PC₇₀BM et sur des substrats flexibles intégrant différents types de TCO sont résumées dans le tableau ci-dessous. Les films minces de CuSCN sont composés de nanofils de l'ordre de 330 nanomètres de longueur et de 80 à 130 nanomètres de diamètre :

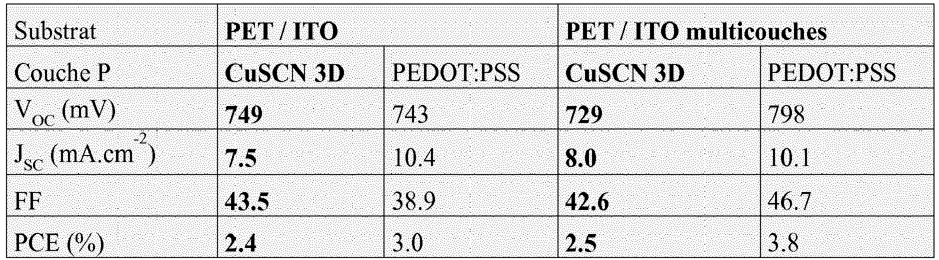

Les différents avantages de la présente invention ressortent clairement de ce qui précède :
- la basse température à laquelle le procédé est mis en oeuvre (20-25°C) permet l'utilisation de substrats flexibles sensibles à la température et une réduction du coût du procédé ;
- il est possible d'obtenir un film mince nanostructuré de CuSCN avec différentes épaisseurs facilement contrôlables par la densité de charge imposée sur la cathode ;
- le film obtenu est mince, nanostructuré et de morphologie contrôlée, c'est-à-dire qu'on peut déterminer sa longueur, son diamètre et la densité des nanofils qui le composent ;
- il n'y a pas besoin de recuit des nanofils de CuSCN, le film obtenu est directement mince, homogène, continu et cristallin ;
- de bonnes performances en cellules OPV peuvent être obtenues : rendement (PCE également connu sous l'acronyme « *Power Conversion efficiency* ») et stabilité.

### REFERENCES

J. Chen, R. Könenkamp. Vertical nanowire transistor in flexible polymer foil. Appl. Phys. Lett. 82, 2003, p. 4782 - 4784.
Y. Ni, Z. Jin, Y. Fu. Electrodeposition of p-type CuSCN thin films by a new aqueous electrolyte with triethanolamine chelation. J. Am. Ceram. Soc., 90, 2007, 2966-2973.
Y. Selk, T. Yoshida, T. Oekermann. Variation of the morphology of electrodeposited copper thiocyanate films. Thin Solid Films, 516, 2008, 7120-7124.
K. Takahashi, S. Suzaka, Y. Sigeyama, T. Yamaguchi, J. Nakamura, K. Murata. Efficiency increase by insertion of electrodeposited CuSCN layer into ITO/organic solid interface in bulk hetero-junction solar cells consisting of polythiophene and fullerene. Chem. Lett., 36, 2007, 762-763.
W. Wu, Z. Jin, Z. Hua, Y. Fu, J. Qiu. Growth mechanisms of CuSCN films electrodeposited on ITO in EDTA-chelated copper(II) and KSCN aqueous solution. Electrochim. Acta, 50, 2005, 2343-2349.
W. Wu, Z. Jin, G Hu, S. Bu. Electrochemical deposition of p-type CuSCN in porous n-type TiO2 films. Electrochim. Acta, 52, 2007, 4804-4808.

## Revendications

1. Procédé d'élaboration, sur un substrat conducteur ou semi-conducteur, de nanofils à base de CuSCN comprenant les étapes suivantes :
- préparation d'une solution aqueuse électrolytique à partir d'un sel de Cu(II) à une concentration inférieure à 120 mM, d'un complexant de Cu(II) de la famille des acides aminocarboxyliques et d'un sel de thiocyanate, ladite solution présentant un pH compris entre 0,1 et 3 ;
- dépôt par voie électrochimique de la solution aqueuse électrolytique sur le substrat.

2. Procédé selon la revendication 1, ***caractérisé* en ce que** la solution aqueuse électrolytique présente un pH compris entre 1 et 2,3, avantageusement égal à 1,7.

3. Procédé selon la revendication 1 ou 2, ***caractérisé* en ce que** le substrat est un métal.

4. Procédé selon la revendication 1 ou 2, ***caractérisé* en ce que** le substrat est formé par au moins une couche en oxyde conducteur transparent, avantageusement disposée sur un support transparent, par exemple en verre ou en plastique.

5. Procédé selon l'une des revendications précédentes, ***caractérisé* en ce que** le sel de Cu(II) est choisi dans le groupe suivant : CuSO₄, CuCl₂ et leurs mélanges.

6. Procédé selon l'une des revendications précédentes, ***caractérisé* en ce que** le complexant de Cu(II) de la famille des acides aminocarboxyliques est sous forme d'un polyacide, avantageusement choisi dans le groupe suivant : EDTA, CDTA, EGTA, DTPA et leurs mélanges.

7. Procédé selon l'une des revendications précédentes, ***caractérisé* en ce que** le sel de thiocyanate est choisi dans le groupe suivant : KCSN, NaCSN et leurs mélanges.

8. Procédé selon l'une des revendications précédentes, ***caractérisé* en ce que** le sel de Cu(II) utilisé pour préparer la solution aqueuse électrolytique a une concentration supérieure ou égale à 5mM et inférieure ou égale à 80mM.

9. Procédé selon l'une des revendications précédentes, ***caractérisé* en ce que** le rapport molaire entre le Cu(II) et le complexant du cuivre dans la solution aqueuse électrolytique est inférieur ou égal à 1/0.8, avantageusement égal à 1/1.

10. Procédé selon l'une des revendications précédentes, ***caractérisé* en ce que** le rapport molaire entre le Cu(II) et le sel de thiocyanate dans la solution aqueuse électrolytique est inférieur ou égal à 1/0.1, avantageusement égal à et 1/0.25.

11. Procédé selon l'une des revendications précédentes, ***caractérisé* en ce que** le dépôt par voie électrochimique est réalisé à une température inférieure à 50°C, avantageusement comprise entre 20 et 30°C.

12. Procédé selon l'une des revendications précédentes, ***caractérisé* en ce que** le dépôt par voie électrochimique est réalisé en mode potentiostatique, préférentiellement à un potentiel compris entre -10 et -480 mV.

13. Procédé selon l'une des revendications 1 à 11, ***caractérisé* en ce que** le dépôt par voie électrochimique est réalisé en mode galvanostatique, préférentiellement avec une densité de courant comprise entre -5 et -550 µA.cm⁻².

14. Procédé de fabrication d'un dispositif optoélectronique, selon lequel le dépôt du semi-conducteur transparent de type p sur un substrat conducteur ou semi-conducteur est réalisé à l'aide du procédé selon l'une des revendications 1 à 13.
